# DEMANDE DE BREVET EUROPEEN

(11) **EP 2 400 252 A1**
(43) Date de publication de la demande: **28.12.2011**
(21) Numéro de dépôt: 11170638.8
(22) Date de dépôt: 21.06.2011
(51) Int. Cl.: F28F 13/00, F21S 8/10, H01L 23/373, F21V 29/00, F21S 8/12

(54) **Dispositif à échange de chaleur, notamment pour véhicule automobile**

(30) Priorité: 24.06.2010 FR 1055046
(71) Demandeur: VALEO VISION, 93012 Bobigny Cedex (FR)
(72) Inventeur: Mornet, Eric, 94130 Nogent sur Marne (FR); Roucoules, Christine, 95170 Deuil la Barre (FR)

(57) **Abrégé**

L'invention concerne un dispositif à échange de chaleur (10), notamment pour un véhicule automobile, ce dispositif comportant :
- au moins une mousse métallique (1),
- un organe thermique (11) en contact direct avec la mousse métallique permettant l'échange de chaleur entre l'organe thermique et la mousse métallique.

## Description

L'invention concerne notamment un dispositif à échange de chaleur.

On connaît par le brevet US 6 397 450 un échangeur de chaleur pour refroidir des modules électroniques de puissance en utilisant une mousse métallique. Cette mousse est comprimée, préalablement à son utilisation, pour obtenir un certain alignement des ligaments afin de favoriser le flux d'air réalisant les échanges de chaleur dans une direction particulière.

On connaît également par la demande de brevet WO 2008/119696 une structure poreuse fixée sur un support par frittage *('sintering'* en anglais).

L'invention concerne notamment l'échange de chaleur par convection, pour chauffer ou refroidir, à l'aide d'une mousse métallique.

Les échanges considérés dans l'invention peuvent être réalisés en convection forcée et/ou naturelle indifféremment. Les mousses métalliques considérées ici sont à cellule ouvertes, ces dernières permettant un écoulement du fluide d'une cellule vers les cellules voisines.

De manière habituelle, une mousse métallique peut comprendre un réseau de ligaments métalliques formant de nombreuses cellules laissant l'air évoluer d'une cellule à un autre.

Ces mousses métalliques permettent un très bon échange de chaleur par convection de la mousse vers un fluide caloporteur (de l'air par exemple et sans limitation), de part la surfaces de contact élevée et les mouvement d'air plus ou moins chaotique (non rectiligne).

A égale performance d'échange dans l'air, le volume de la mousse nécessaire peut être environ 30% plus faible qu'avec une technologie à ailettes.

L'invention vise notamment à améliorer les échanges de chaleur entre un organe thermique et une mousse métallique.

L'invention a ainsi pour objet un dispositif à échange de chaleur, notamment pour un véhicule automobile, ce dispositif comportant :
- au moins une mousse métallique,
- un organe thermique en contact direct avec la mousse métallique permettant l'échange de chaleur entre l'organe thermique (qui forme notamment une source de calories ou de frigories) et la mousse métallique.

Le cas échéant, le dispositif n'utilise aucun fluide de refroidissement autre que de l'air, passant à travers les cellules de la mousse.

Au sens de la présente invention, un contact direct signifie notamment un contact sans interposition de matière supplémentaire pour le contact entre la mousse et l'organe thermique.

De préférence, la mousse métallique est déformée avant ou pendant l'assemblage, notamment étant localement comprimée aux zones de contact, à la jonction avec l'organe thermique. Ceci présente l'avantage d'augmenter la surface de contact entre l'organe thermique.

La compression locale des fibres/ ligaments de mousse peut permettre d'augmenter la surface de contact entre la mousse et l'organe thermique. Une surface plus importante permet de limiter les pertes en température à l'interface, car ces dernières sont proportionnelles à la surface.

La présente invention peut ainsi être supérieure, d'un point de vue thermique, par rapport à, par exemple, une solution utilisant un collage ou une soudure, solution qui résulte en une interface thermique qui n'est pas optimum car ne conduisant pas la chaleur suffisamment efficacement et en un contact avec la mousse qui est restreint.

De préférence, l'organe thermique et la mousse métallique sont assemblés ensemble, notamment en force, de manière uniquement mécanique, notamment sans soudure ou brasure.

Une solution de collage ou soudure présente l'inconvénient d'avoir une étape de procédé supplémentaire et peut impliquer des limitations dans le style du produit fini et un coût plus élevé.

On peut néanmoins prévoir, le cas échéant, quelques points de soudure locaux, par exemple et sans limitation, avec un laser, pour assurer la bonne tenue mécanique de la mousse avec les contraintes qu'elle pourrait subir (choc thermique, relaxation de contrainte...).

Dans ce cas, la soudure est local et sans apport de matière et ne participe que très peu au transfert thermique du fait de la faible surface (inférieure à 10% de la surface de contact mousse organe thermique).

Dans un exemple de mise en oeuvre de l'invention, la mousse métallique est localement déformée, notamment localement comprimée, à la jonction avec l'organe thermique.

Si on le souhaite, la mousse métallique présente, au moins localement, notamment dans une région éloignée de la jonction avec l'organe thermique, une distribution isotrope des cellules de la mousse.

Au sein de cette région de la mousse, le coefficient de diffusion thermique est de préférence le même dans n'importe quelle direction.

Par exemple, l'organe thermique et la mousse métallique sont fixés ensemble par une fixation à force.

Avantageusement l'organe thermique est fixé à la mousse métallique en déformant localement cette mousse, au moins dans une zone de contact entre l'organe thermique et la mousse métallique.

Dans un exemple de mise en oeuvre de l'invention, la mousse métallique comporte au moins un passage d'insertion agencé pour permettre l'insertion, notamment à force, d'une portion de l'organe thermique dans ce passage.

Pour réaliser le montage en force, la surface du passage d'insertion est en grande partie ou en totalité contenue dans la surface de la portion de l'organe thermique s'insérant dans la mousse métallique.

Ce passage peut par exemple être réalisé par découpe et/ou perçage de la mousse.

Ce passage d'insertion de la mousse peut être formé par un orifice, par exemple de forme cylindrique, cet orifice pouvant être traversant ou non.

En variante, ce passage est formé par une fente, par exemple de section rectangulaire.

La section du passage est de préférence plus faible que celle de la portion de l'organe thermique qui va venir s'insérer dedans.

Le cas échéant, la mousse comporte une pluralité de passages d'insertion, notamment disposés de manière sensiblement parallèle.

Cette disposition a en effet l'avantage de faciliter la mise en place pendant l'assemblage.

En variante, la mousse comporte un unique passage d'insertion.

Dans un exemple de mise en oeuvre de l'invention, l'organe thermique comporte une pluralité de portions s'insérant chacune dans un passage d'insertion de la mousse, cette pluralité de portions de l'organe thermique pouvant être sensiblement parallèles.

Par exemple, la portion de l'organe thermique s'insérant dans le passage d'insertion de la mousse comporte une ailette ou un picot.

L'invention peut ainsi permettre de supprimer le collage et d'assurer la fixation en comprimant la mousse entre deux ailettes de l'organe thermique.

Le cas échéant, la mousse est percée pour y insérer en force les ailettes.

Ceci peut nécessiter d'avoir un perçage de la mousse avec une section plus petite que celle de l'ailette pour s'assurer que la mousse vient bien en contact avec l'ailette.

L'invention permet en outre de réduire fortement les coûts de fabrication.

De plus le contact entre les ailettes ou picots et la mousse est augmenté.

En effet, durant la compression de la mousse, les fibres (ou ligaments) de la mousse se compriment sur l'organe thermique et la partie en contact augmente, ce qui assure une meilleure conduction de la chaleur des ailettes ou picots vers les fibres de la mousse.

Si on le souhaite, l'organe thermique comporte une tige ou une conduite conductrice de chaleur (caloduc) et la portion de l'organe thermique s'insérant dans le passage d'insertion de la mousse correspond à une portion de cette tige ou cette conduite.

Si on le souhaite, l'organe thermique comporte un tube dans lequel circule un premier fluide caloporteur lié à la source de calories ou frigories. Le tube s'insère dans la mousse qui échange avec un deuxième fluide caloporteur.

Dans un exemple de mise en oeuvre de l'invention, l'organe thermique comporte une portion en plaque avantageusement en contact avec une face extérieure de la mousse.

Le cas échéant, l'organe thermique comporte une pluralité d'ailettes et une portion en forme de plaque, chacune des ailettes se raccordant à cette portion en forme de plaque par exemple par l'intermédiaire d'un coude.

L'organe thermique peut être assemblé à une seule mousse métallique.

En variante, l'organe thermique est assemblé avec au moins deux mousses métalliques, distantes l'une de l'autre ou en contact l'une avec l'autre, avec des propriétés thermiques différentes ou identiques.

Dans un exemple de mise en oeuvre de l'invention, le passage d'insertion de la mousse correspond initialement, avant l'insertion de la portion correspondante de l'organe thermique, à une préforme de passage.

En variante, le passage d'insertion sur la mousse est formé de manière concomitante à l'insertion dans la mousse de la portion correspondante de l'organe thermique. Dans ce cas, ce passage n'est pas préformé.

Si on le souhaite, lors de l'insertion dans la mousse de la portion correspondante de l'organe thermique, cette portion provoque une déformation de la mousse et notamment comprime la mousse au voisinage du passage d'insertion.

La portion de l'organe thermique s'insérant dans un passage d'insertion de la mousse peut par exemple traverser la mousse de part en part.

Dans un exemple de mise en oeuvre de l'invention, l'organe thermique comporte au moins deux doigts/picots (ou ailettes ayant une dimension au moins 5 fois plus grande que les deux autres). Ces doigts/picots sont en contact avec la mousse et assure le contact thermique. Ces doigts/picots peuvent être coudé en un ou plusieurs endroits.

L'organe thermique peut être obtenu par l'un des procédés suivants : estampage de tôle, injection, extrusion, assemblage par soudure...

Dans un exemple de mise en oeuvre de l'invention, des passages d'insertion ne sont pas nécessaires dans la mousse métallique.

La mousse métallique vient se positionner entre les doigts/picots. Dans le cas d'une mousse de forme rectangulaire, la mousse est comprimée par ses deux faces opposées par au moins une face de l'organe thermique d'un coté et au moins une face de l'organe thermique de l'autre coté.

Dans une variante de l'invention, au moins deux doigts/picots positionnés dans un premier plan et au moins un doigt/picot dans une direction sensiblement parallèle au premier plan sont utilisés pour assurer le contact avec la mousse.

Dans une autre variante, une des faces de contact est réalisée par une plaque qui peut servir de support à la source de calories et / ou frigories. L'autre faces est réalisée par des doigts/picots, coudé au moins une fois, de manière à être sensiblement parallèle à la plaque.

Dans un exemple d'application, les doigts sont traversant par rapport à la mousse. L'obtention du parallélisme est donc réalisée en deux fois (avant et après insertion de la mousse).

Dans un autre cas d'application, les doigts viennent recouvrir la mousse. Le parallélisme est obtenu avant insertion de la mousse. On peut prévoir de venir couder une autre fois les doigts de manière à bloquer toute sortie de la mousse.

Dans un exemple de mise en oeuvre de l'invention, l'assemblage de la mousse et de l'organe thermique peut être obtenu par contact par l'intérieur de la mousse et par contact par l'extérieur de la mousse.

Dans un exemple de mise en oeuvre de l'invention, l'organe thermique porte au moins une source de lumière, notamment une LED (l'organe thermique sert comme support de LED), et notamment porte un circuit électrique de la LED.

De préférence, le dispositif est agencé en dispositif d'éclairage et/ou de signalisation de véhicule automobile.

L'invention a également pour objet un procédé pour assembler un organe thermique avec une mousse métallique, le procédé comportant l'étape suivante :
- assembler l'organe thermique avec la mousse de manière directe, notamment sans apport de matière, et sans frittage.

Le procédé peut comporter l'étape suivante :
- insérer une portion de l'organe thermique dans un passage d'insertion de la mousse.

Avantageusement la mousse métallique est au moins localement comprimée lors de l'assemblage de l'organe thermique et la mousse métallique.

L'invention pourra être mieux comprise à la lecture de la description détaillée qui va suivre, d'exemples de mise en oeuvre non limitatifs de l'invention, et à l'examen du dessin annexé, sur lequel :
- la figure 1 représente, schématiquement et partiellement, en perspective, des mailles d'une mousse métallique,
- la figure 2 représente, schématiquement et partiellement, en perspective, un dispositif d'échange de chaleur conforme à un exemple de mise en oeuvre de l'invention, avant assemblage de l'organe thermique avec la mousse métallique,
- la figure 3 est une vue de dessus du dispositif de la figure 2, après assemblage,
- la figure 4 représente, schématiquement et partiellement, en perspective, un dispositif d'échange de chaleur conforme à un autre exemple de mise en oeuvre de l'invention, avant assemblage de l'organe thermique avec la mousse métallique,
- les figures 5 et 6 représentent, schématiquement et partiellement, en perspective, un dispositif d'échange de chaleur conforme à un autre exemple de mise en oeuvre de l'invention, respectivement avant et après l'assemblage, et
- les figures 7 à 10 représentent, schématiquement et partiellement, en perspective, un dispositif d'échange de chaleur conforme à d'autres exemples de mise en oeuvre de l'invention.

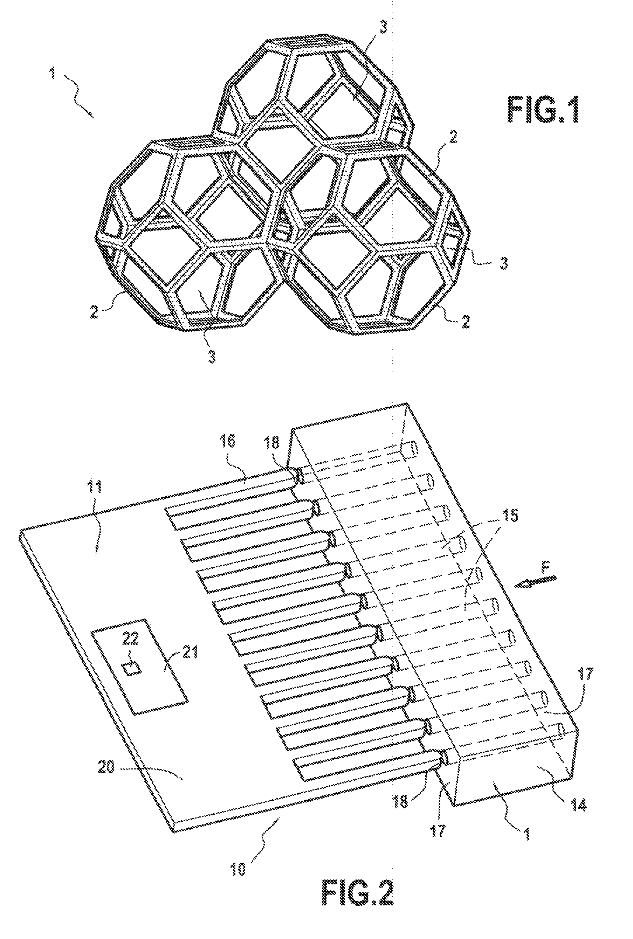

On a représenté sur la figure 1 une mousse métallique 1 comprenant un réseau de ligaments métalliques 2 formant des cellules ouvertes 3 afin de présenter une porosité.

On a représenté sur la figure 2 un dispositif à échange de chaleur 10, pour un véhicule automobile, ce dispositif 10 comportant :
- une mousse métallique 1,
- un organe thermique 11 en contact direct avec la mousse métallique 1 permettant l'échange de chaleur entre l'organe thermique 11 et la mousse métallique 1.

Dans l'exemple décrit, le dispositif 10 n'utilise aucun fluide de refroidissement autre que de l'air (fluide caloporteur), passant à travers les cellules 3 de la mousse 1.

L'organe thermique 11 et la mousse métallique 1 sont assemblés ensemble de manière uniquement mécanique, notamment sans soudure ou brasure entre ces éléments.

Par exemple, la mousse métallique 1 est localement déformée à la jonction 13 avec l'organe thermique 11 (voir figure 2 par exemple).

Dans l'exemple décrit, la mousse métallique 1 présente, dans une région 14 éloignée de la jonction 13 avec l'organe thermique 11, une distribution isotrope des cellules 3 de la mousse.

Au sein de cette région 14 de la mousse, le coefficient de diffusion thermique est de préférence le même dans n'importe quelle direction.

L'organe thermique 11 est fixé à la mousse métallique 1 en déformant localement cette mousse, au moins dans une zone de jonction 13 entre l'organe thermique 11 et la mousse métallique 1.

Dans l'exemple décrit, la mousse métallique 1 comporte une pluralité de passages d'insertion 15 agencés pour permettre chacun l'insertion à force, d'une portion 16 de l'organe thermique 11 dans ce passage 15.

Ces passages 15 sont par exemple réalisés par perçage de la mousse 1.

Chaque passage d'insertion 15 de la mousse est un orifice de forme cylindrique, cet orifice 15 étant traversant de manière à déboucher sur deux faces 17 opposées et parallèles de la mousse 1. Ces faces 17 peuvent être planes.

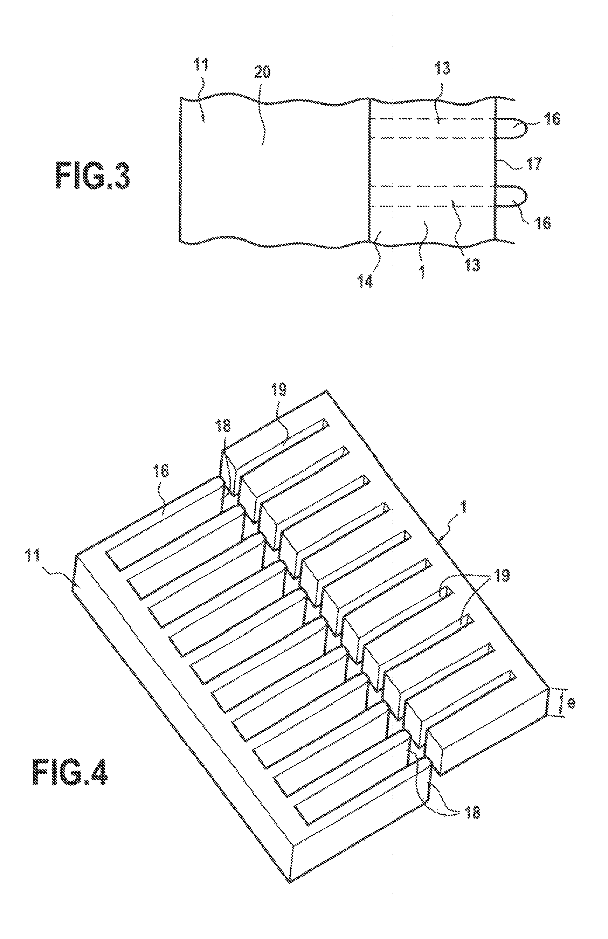

En variante, comme illustré sur la figure 4, les passages peuvent être formés par des fentes 19, par exemple de section rectangulaire, ces fentes s'étendant par exemple suivant l'épaisseur « e »de la mousse 1.

Dans les exemples des figures 2 à 4, les portions 16 de l'organe thermique 11 s'insérant dans les passages d'insertion 15 ou 19 de la mousse 1 sont formées chacune par une ailette.

Ces ailettes 16 sont parallèles entre elles.

Chaque ailette 16 comporte à son extrémité libre un biseau 18 permettant de faciliter l'insertion de cette ailette 16 dans l'orifice 15 correspondant.

La flèche F (voir figure 2) désigne la direction d'insertion de la mousse 1 sur l'organe thermique 11.

Chaque orifice 15 de la mousse peut présenter une section plus petite que celle de l'ailette 16 pour s'assurer que la mousse 1 vient bien en contact avec l'ailette 16.

Le contact entre les ailettes 16 et la mousse 1 est augmenté.

En effet, durant la compression de la mousse 1, les fibres (ou ligaments) de la mousse se compriment sur les ailettes 16 et la partie en contact augmente, ce qui assure une meilleure conduction de la chaleur des ailettes 16 vers les fibres de la mousse 1.

Chaque ailette 16 de l'organe thermique 11 s'insère dans le passage d'insertion 15 associé de la mousse en faisant saillie hors de ce passage 15, en fin d'insertion (voir figure 3).

Dans l'exemple des figures 2 et 3, l'organe thermique 11 comporte une portion en plaque 20 portant un circuit électrique 21 intégrant une LED 22.

Dans cet exemple, la plaque 20 est en porte-à-faux par rapport au bloc de mousse 1.

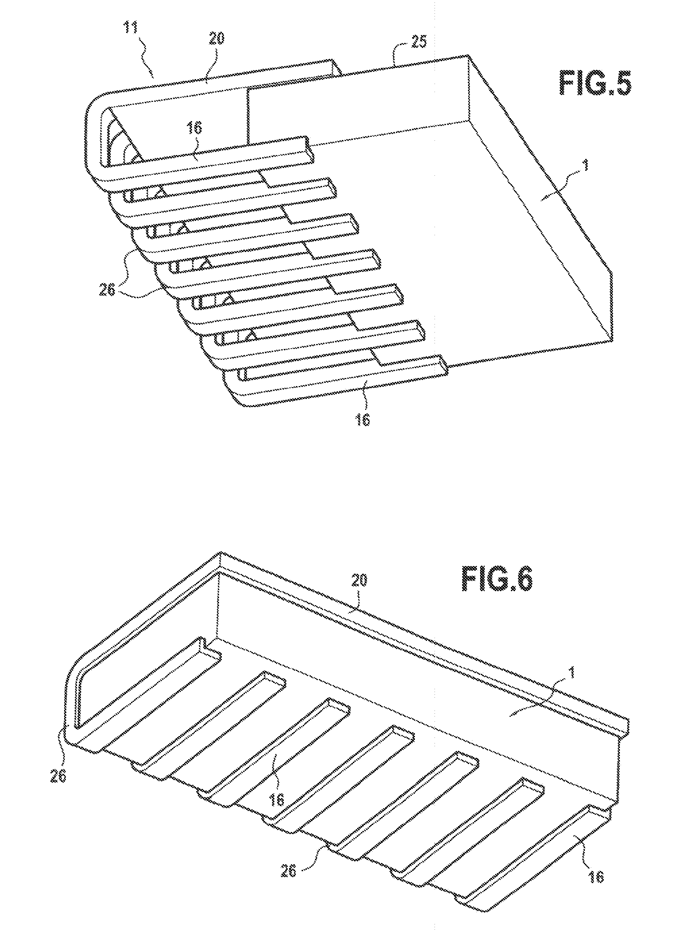

En variante, comme illustré sur les figures 5 et 6, la plaque 20 de l'organe thermique 11 est en contact avec une face extérieure 25 de la mousse 1.

Dans cet exemple, une pluralité d'ailettes 16 se raccordent la portion en plaque 20, chacune des ailettes 16 se raccordant à cette portion en plaque 20 par l'intermédiaire d'un coude 26, notamment un coude en forme de U.

La mousse 1 est ainsi emprisonnée entre la portion en plaque 20 et les ailettes 16, comme illustré sur la figure 6.

Dans les exemples décrits ci-dessus, la mousse 1 présente une forme sensiblement en pavé.

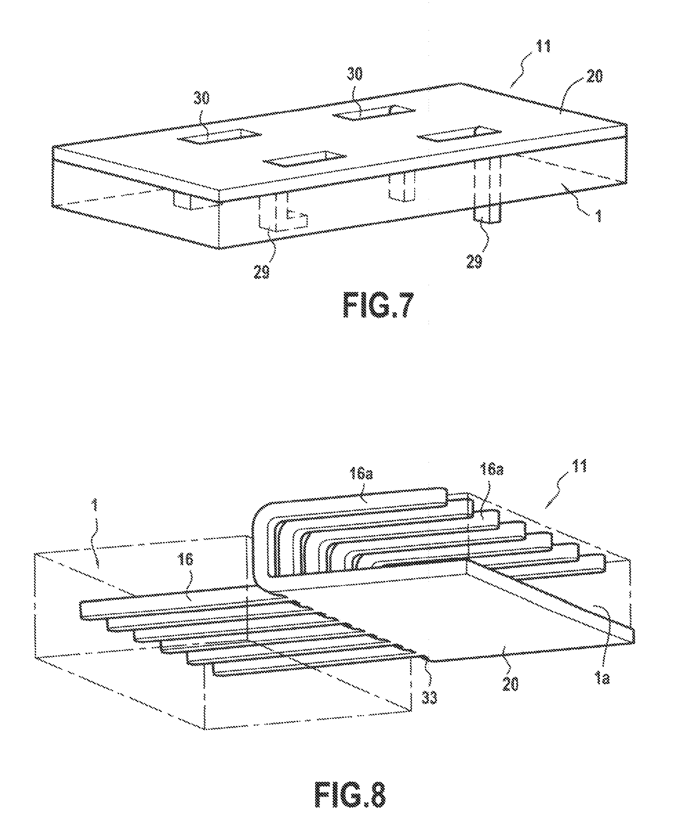

Dans un autre exemple de mise en oeuvre de l'invention illustré à la figure 7, l'organe thermique 11 comporte une portion en plaque 20 avec des pattes 29 réalisées par découpe et pliage de cette portion en plaque 20, laissant ainsi apparaître des trous 30 dans la portion en plaque 20.

Chaque patte 29 traverse l'épaisseur de la mousse 1 et est repliée à son extrémité libre pour maintenir la mousse solidaire de l'organe thermique 11.

Dans un autre exemple de mise en oeuvre de l'invention illustré à la figure 8, l'organe thermique 11 comporte une portion en plaque 20 avec, alternativement, partant d'un bord 33, des ailettes rectilignes 16 et des ailettes recourbées 16a.

Les ailettes rectilignes 16 pénètrent dans un bloc de mousse 1, et les ailettes recourbées 16a pénètrent dans un autre bloc de mousse 1a.

Dans cet exemple, le dispositif 1 utilise deux blocs de mousse.

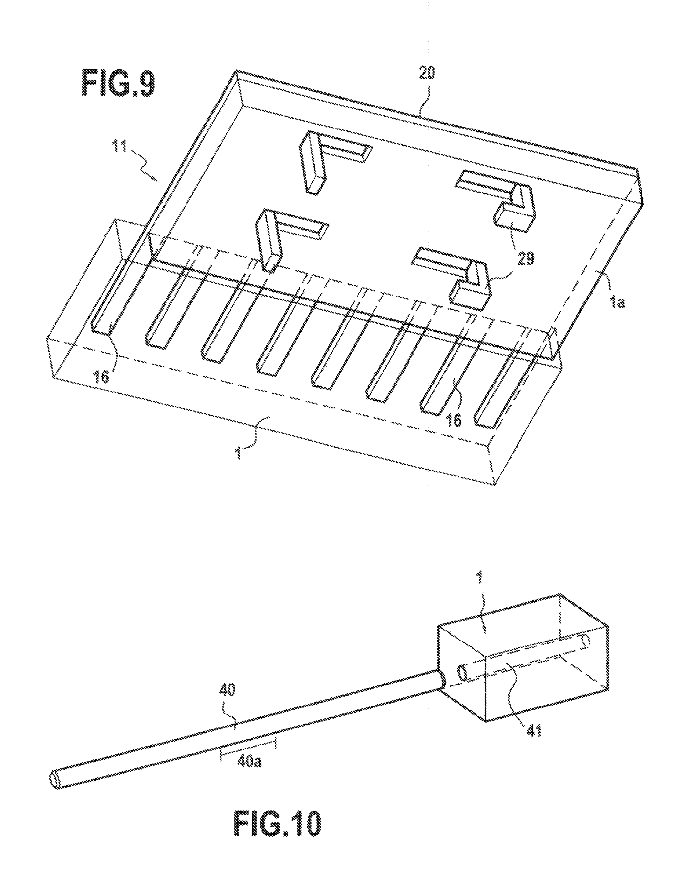

Dans un autre exemple de mise en oeuvre de l'invention illustré à la figure 9, l'organe thermique 11 comporte une portion en plaque 20 avec à la fois des ailettes droites 16 telles que celles décrites en référence à la figure 2, et des pattes 29 telles que celles décrites à la figure 7.

Ces ailettes 16 et ces pattes 29 sont perpendiculaires entre elles, et sont respectivement associées à un bloc de mousse 1 et 1a.

Dans un autre exemple de mise en oeuvre de l'invention illustré à la figure 10, l'organe thermique 11 comporte une tige ou une conduite conductrice de chaleur 40 (caloduc) et la portion de l'organe thermique s'insérant dans le passage d'insertion 41 (de forme cylindrique) de la mousse 1 correspond à une portion 40a de cette tige ou cette conduite.

Le dispositif 1 est agencé en dispositif d'éclairage et/ou de signalisation de véhicule automobile, par exemple un projecteur pour produire un éclairage route et/ou de croisement.

Dans les applications d'insertion en force, il peut être nécessaire de s'assurer que la mousse métallique reste solidaire de l'organe métallique.

L'avantage peut être d'éviter la prise de jeu dans le temps, la production de poussière et la perte de la fonction de contact dans le temps.

Cela peut être obtenu en bloquant aux extrémités par exemple, par repliage d'une partie de l'organe métallique, ou par écrasement local d'une extrémité de mousse non participante au refroidissement.

Une autre solution pourrait être de réaliser des points de soudure locaux ayant pour fonction uniquement le maintien mécanique.

Enfin une dernière solution serait l'ajout d'un élément additionnelle telle une vis ou plusieurs vis, pour maintenir l'organe métallique et la mousse de manière solidaire.

## Revendications

1. Dispositif à échange de chaleur (10), notamment pour un véhicule automobile, ce dispositif comportant :
- au moins une mousse métallique (1),
- un organe thermique (11) en contact direct avec la mousse métallique permettant l'échange de chaleur entre l'organe thermique et la mousse métallique.

2. Dispositif selon la revendication précédente, **caractérisé par le fait que** l'organe thermique et la mousse métallique (1) sont assemblés ensemble de manière uniquement mécanique, notamment sans soudure ou brasure, notamment avec déformation locale à la jonction.

3. Dispositif selon l'une des revendications précédentes, **caractérisé par le fait que** la mousse métallique (1) est localement déformée à la jonction avec l'organe thermique.

4. Dispositif selon l'une des revendications précédentes, **caractérisé par le fait que** l'organe thermique (11) et la mousse métallique (1) sont fixés ensemble par une fixation à force.

5. Dispositif selon l'une des revendications précédentes, **caractérisé par le fait que** la mousse métallique (1) comporte au moins un passage d'insertion (15) agencé pour permettre l'insertion, notamment à force, d'une portion (16) de l'organe thermique dans ce passage.

6. Dispositif selon l'une des revendications précédentes, **caractérisé par le fait que** l'organe thermique comporte une pluralité de portions (16) s'insérant chacune dans un passage d'insertion de la mousse, cette pluralité de portions de l'organe thermique pouvant être sensiblement parallèles.

7. Dispositif selon la revendication précédente, **caractérisé par le fait que** la portion de l'organe thermique s'insérant dans le passage d'insertion de la mousse comporte une ailette (16) ou un picot.

8. Dispositif selon l'une des revendications 1 à 6, **caractérisé par le fait que** l'organe thermique comporte une tige ou une conduite conductrice de chaleur (40) et la portion de l'organe thermique s'insérant dans le passage d'insertion de la mousse correspond à une portion de cette tige ou cette conduite.

9. Dispositif selon l'une des revendications précédentes, **caractérisé par le fait que** l'organe thermique porte au moins une source de lumière, notamment une LED (22).

10. Dispositif selon l'une des revendications précédentes, **caractérisé par le fait qu'**il est agencé en dispositif d'éclairage (1) et/ou de signalisation de véhicule automobile.

11. Procédé pour assembler un organe thermique avec une mousse métallique, comportant l'étape suivante :
- assembler l'organe thermique avec la mousse de manière directe.

12. Procédé selon la revendication précédente, comportant l'étape suivante :
- insérer une portion de l'organe thermique (11) dans un passage d'insertion de la mousse
